# EUROPEAN PATENT APPLICATION

(11) **EP 2 040 311 A2**
(43) Date of publication of application: **25.03.2009**
(21) Application number: 08252799.5
(22) Date of filing: 22.08.2008
(51) Int. Cl.: H01L 31/18, H01L 31/048, H01L 31/0224

(54) **Solar cell manufacturing method**

(30) Priority: 24.08.2007 JP 2007219077
(71) Applicant: Sanyo Electric Co., Ltd., Osaka 570-8677 (JP)
(72) Inventor: Nakai, Takuo, Moriguchi-shi, Osaka 570-8677 (JP); Shima, Masaki, Moriguchi-shi, Osaka 570-8677 (JP)
(74) Representative: Calderbank, Thomas Roger

(57) **Abstract**

According to a solar cell manufacturing method of an embodiment, in a process of forming a surface protection layer by transferring a resin material applied to a cylindrical surface of a cylindrical blanket, to a light receiving surface of a solar cell substrate, the blanket is rotated on the light receiving surface of the solar cell substrate in a first direction in which the multiple thin wire electrodes extend.

## Description

This application is based upon and claims the benefit of priority from the prior Japanese Patent Application No. P 2007-219077, filed on August 24, 2007; the entire contents of which are incorporated herein by reference.

The present invention relates to a method for manufacturing a solar cell including a surface protection layer.

Solar cells are expected as new energy sources since the solar cells are capable of directly converting clean and inexhaustibly-supplied solar light into electricity.

In general, a solar cell includes a photoelectric conversion part configured to generate photogenerated carriers by receiving light, as well as thin wire electrodes and a bus bar electrode formed on the photoelectric conversion part. The thin wire electrodes collect photogenerated carriers from the photoelectric conversion part. The bus bar electrode collects photogenerated carriers from the thin wire electrodes. A wiring member for connecting the solar cells with each other is mounted on the bus bar electrode.

Regarding such solar cell, one known technique is to form a surface protection layer on a surface of a solar cell for the purpose of mechanically protecting the solar cell and improving the moisture resistance of the solar cell (for example, see Japanese Patent Application Publication No. 2007-141967).

Such a surface protection layer is formed by application of a synthetic resin to the surface of a solar cell in a spray bonding method or screen printing method.

In the case where the surface protection layer is formed in the spray bonding method, however, the formation process is not simple and easy because it is necessary to mask the bus bar electrode where the wiring member is to be mounted.

In addition, when the surface protection layer is formed in the screen printing method, a synthetic resin with high viscosity needs to be used in order to prevent the synthetic resin from spreading after the application. For this reason, in the case of using the screen printing, the degree of freedom in synthetic resin material selection is low.

Under these circumstances, a printing method with a blanket, for instance, an offset printing method is considered as usable to form a surface protection layer. By using these printing methods, a synthetic resin patterned in advance can be transferred to the surface of the solar cell. Accordingly, these methods do not require the surface of the solar cell to be masked while providing a high degree of freedom in synthetic resin material selection.

When the surface protection layer is formed by use of the printing method with a blanket, however, the surface protection layer is sometimes not formed around the thin wire electrodes. This uneven formation of the surface protection layer causes a problem of decreasing the function of the surface protection layer.

Against this background, the present invention has been made in consideration of the foregoing problem, and aims to provide a method for manufacturing a solar cell with an improved moisture resistance by forming a surface protection layer in a printing method with a blanket.

A solar cell manufacturing method according to an aspect of the present invention is summarized as a method of manufacturing a solar cell including: a solar cell substrate having a photoelectric conversion part configured to generate photogenerated carriers by receiving light, and multiple thin wire electrodes configured to collect the photogenerated carriers from the photoelectric conversion part; and a surface protection layer formed on a main surface of the solar cell substrate. This method includes a step A of forming the solar cell substrate by forming the multiple thin wire electrodes each extending in a predetermined direction on a main surface of the photoelectric converter; a step B of applying a resin material to a cylindrical surface of a cylindrical blanket; and a step C of forming the surface protection layer by transferring the resin material to the main surface of the solar cell substrate. In addition, in the step C, the blanket is rotated on the main surface of the solar cell substrate in the predetermined direction.

In this way, the blanket rotates on the main surface of the solar cell substrate in the predetermined direction, and thus the blanket does not need to run over the multiple thin wire electrodes one by one. This prevents a gap from occurring between the blanket and a portion around the thin wire electrode. Consequently, the surface protection layer can be uniformly formed on the main surface of the solar cell substrate.

Since the surface protection layer can be uniformly formed as described above, the moisture resistance of the solar cell is improved and accordingly the solar cell substrate is prevented from being damaged.

In the forgoing aspect of the present invention, it is more preferable that: the solar cell substrate further include a bus bar electrode configured to collect the photogenerated carriers from the multiple thin wire electrodes; the step A include forming the bus bar electrode on the main surface of the photoelectric conversion part so that the bus bar electrode intersects the multiple thin wire electrodes; and the step B include transferring the resin material so that the resin material is located away from the bus bar electrode.

In the drawings:
Fig. 1 is a perspective view of a solar cell 1 according to an embodiment of the present invention.
Fig. 2 is a plan view of the solar cell 1 according to this embodiment.
Fig. 3 is a diagram for explaining a method of manufacturing the solar cell 1 according to this embodiment (No. 1).
Fig. 4 is a cross sectional view as viewed from a F1 direction in Fig. 3.
Fig. 5 is a magnified photograph of a light receiving surface of a solar cell in an example.
Fig. 6 is a magnified photograph of a light receiving surface of a solar cell in a comparative example.
Fig. 7 is a diagram showing results of moisture resistance tests of the example and the comparative example.
Fig. 8 is a plan view on a light receiving surface side of a solar cell according to another embodiment.

Hereinafter, an embodiment of the present invention will be described with reference to the accompanying drawings. In the following description of the drawings, the same or similar reference numerals are attached to the same or similar elements. In addition, it should be noted that these drawings are schematic ones, and show the dimensions of the elements different from those of real ones. Thus, the specific dimensions must be determined in consideration of the following description. Moreover, it is obvious that the drawings include parts showing the dimensional relationships and ratios different from each other.

### (Configuration of Solar Cell)

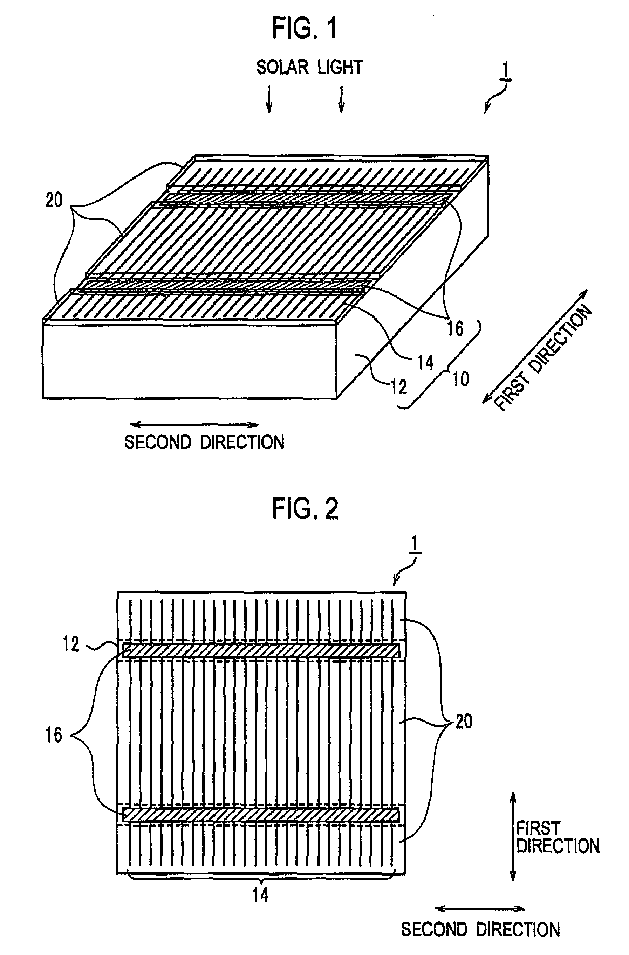

A schematic configuration of a solar cell 1 is described by referring to Figs. 1 and 2. Fig. 1 is a perspective view of a solar cell 1 according to an embodiment. Fig. 2 is a plan view of the solar cell 1 according to this embodiment.

The solar cell 1 includes a solar cell substrate 10 and a surface protection layer 20 as shown in Fig. 1.

The solar cell substrate 10 includes a photoelectric conversion part 12, thin wire electrodes 14 and bus bar electrodes 16. Moreover, the solar cell substrate 10 includes a light receiving surface that receives solar light, and a back surface provided on an opposite side to the light receiving surface. Both the light receiving surface and the back surface of the solar cell substrate 10 are main surfaces of the solar cell substrate 10. In this embodiment, the surface protection layer 20 is formed on the light receiving surface of the solar cell substrate 10.

The photoelectric conversion part 12 generates photogenerated carriers by receiving light. The photogenerated carriers are electron holes and electrons generated from solar light absorbed by the photoelectric conversion part 12. The photoelectric conversion part 12 includes a light receiving surface that receives solar light and a back surface provided on an opposite side to the light receiving surface. Both the light receiving surface and the back surface of the photoelectric conversion part 12 are main surfaces of the photoelectric conversion part 12.

The photoelectric conversion part 12 internally includes an n-type region and a p-type region, and a semiconductor junction is formed at an interface between the n-type region and the p-type region. The photoelectric conversion part 12 can be formed of a semiconductor substrate composed of any of semiconductor materials including: a crystal-based semiconductor material such as single crystal Si and polycrystal Si; a compound semiconductor material such as GaAs and InP; and the like. Incidentally, the photoelectric conversion part 12 may have a so-called HIT structure, i.e., a structure having the property of a heterojunction interface improved by inserting a substantially-intrinsic amorphous silicon layer between a single crystal silicon substrate and an amorphous silicon layer.

The thin wire electrodes 14 are collecting electrodes configured to collect photogenerated carriers from the photoelectric conversion part 12. Multiple thin wire electrodes 14 are each formed to extend in a first direction on the light receiving surface of the photoelectric conversion part 12 as shown in Figs. 1 and 2. The thin wire electrodes 14 according to this embodiment are each formed into a line shape, and expand, as a whole, over a substantially entire area on the light receiving surface of the photoelectric conversion part 12. The form and number of thin wire electrodes 14 are set in consideration of a ratio of a light receiving area to the light receiving surface of the solar cell substrate 10, and the efficiency of collecting photogenerated carriers. The thin wire electrode 14 can be formed by use of a conductive resin paste obtained by adding conductive particles as fillers into a resin material as a binder, for example, but may be formed of another material.

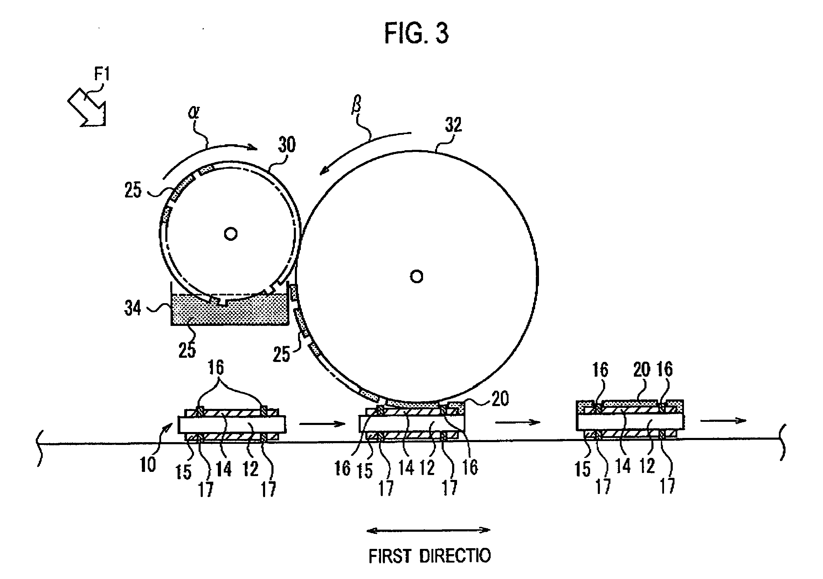

Note that the solar cell substrate 10 according to this embodiment also includes thin wire electrodes 15 (not shown in Figs. 1 and 2, but see Fig. 3) that are formed on the back surface of the photoelectric conversion part 12 in the same pattern as that of the thin wire electrodes 14.

The bus bar electrodes 16 are collecting electrodes that collect the photogenerated carriers from the thin wire electrodes 14. As shown in Figs. 1 and 2, the bus bar electrodes 16 are each formed on the light receiving surface of the photoelectric conversion part 12 to extend in a second direction substantially perpendicular to the first direction. In short, the bus bar electrode 16 is formed to intersect with the thin wire electrodes 14. Although two bus bar electrodes 16 are formed in this embodiment, the number of the bus bar electrodes 16 is set to any appropriate number in consideration of the size and the like of the photoelectric conversion part 12. The bus bar electrode 16 can be formed of the same material as that of the thin wire electrode 14.

Note that the solar cell substrate 10 also includes bus bar electrodes 17 (not shown in Figs. 1 and 2, but see Fig. 3) that are formed on the back surface of the photoelectric conversion part 12 in the same pattern as that of the bus bar electrode 16.

Here, a wiring member used to electrically connect the solar cells 1 with each other is connected to the bus bar electrode 16. Specifically, a wiring member is connected to the bus bar electrode 16 formed on the light receiving surface of the photoelectric conversion part 12 included in a first solar cell 1, and the bus bar electrode 17 formed on the back surface of the photoelectric conversion part 12 included in a solar cell 1 adjacent to the first solar cell 1. A low resistance element, such as copper, formed in a thin plate shape or twisted line shape can be used as the wiring member. The surface of the low resistance element may be coated with a soft conductor (for example, a eutectic crystal solder or the like) .

Next, the surface protection layer 20 included in the solar cell 1 is described. The surface protection layer 20 is formed on the light receiving surface of the solar cell substrate 10. As described above, the surface protection layer 20 is formed away from the bus bar electrodes 16 because the wiring member is to be connected to the bus bar electrode 16. Accordingly, the surface protection layer 20 according to this embodiment is composed of three laminations as shown in Figs. 1 and 2. Incidentally, the surface protection layer 20 may be formed as a single lamination in a way that the three laminations are coupled to each other in the second direction outside the bus bar electrodes 16.

The surface protection layer 20 can be formed by use of a resin material such as EVA, PVA, PVB, silicone, acryl, epoxy, and polysilazane. In addition, such resin material may also be added with an additive such as silicon oxide, aluminium oxide, magnesium oxide, titanium oxide and zinc oxide.

The surface protection layer 20 can be formed by transferring any of the aforementioned resin materials to the light receiving surface of the solar cell substrate 1 in the offset printing method, for example.

### (Solar Cell Manufacturing Method)

Hereinafter, description will be provided for a method of manufacturing the solar cell 1 according to this embodiment.

To begin with, a process (process A) of forming the solar cell substrate 10 is explained. The photoelectric conversion part 12 is prepared. Here, a semiconductor substrate having a pn semiconductor junction as a basic structure is used as the photoelectric conversion part 12.

Next, the collecting electrodes (the thin wire electrodes 14 and the bus bar electrodes 16) are formed on the light receiving surface of the photoelectric conversion part 12 in a printing method such as a screen printing method. More specifically, an epoxy-based thermoset silver paste is firstly disposed in a predetermined pattern on the light receiving surface and the back surface of the photoelectric conversion part 12.

Here, the predetermined pattern for disposing the silver paste is a comb-like shape as shown in Figs. 1 and 2. Accordingly, multiple thin wire electrodes 14 are each formed to extend in the first direction. Two bus bar electrodes 16 are each formed to extend in the second direction substantially perpendicular to the first direction.

After that, the silver paste is heated to evaporate its solvent, and then the silver paste is further heated to be dried completely. In this way, the solar cell substrate 10 is fabricated.

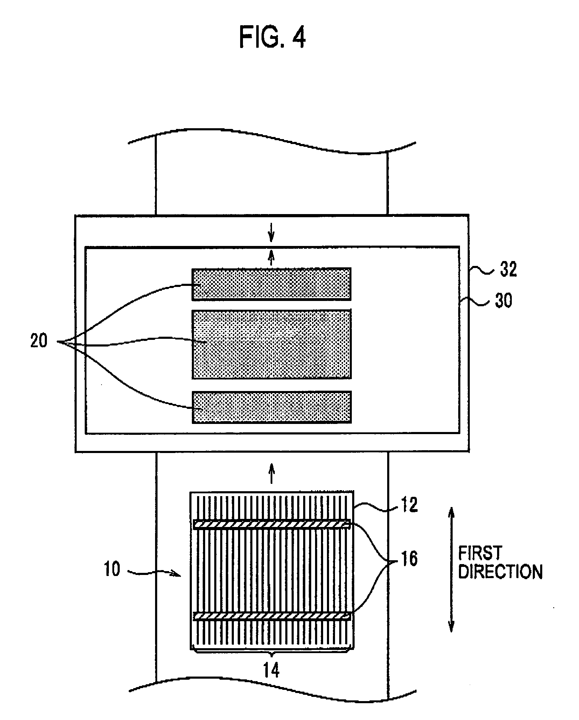

Here, a process of forming the surface protection layer 20 by use of an offset printing apparatus is described by referring to Figs. 3 and 4. Fig. 3 is a diagram for explaining the method of forming the surface protection layer 20 by use of the offset printing apparatus. Fig. 4 is a cross sectional view as viewed from a F1 direction in Fig. 3.

In the first place, a configuration of the offset printing apparatus is explained. As shown in Fig. 3, the offset printing apparatus includes a cylindrical printing cylinder 30, a cylindrical blanket 32 and a resin bath 34.

The printing cylinder 30 rotates about a shaft center of the printing cylinder 30 in an arrow α direction as shown in Fig. 3. Recessed portions in a predetermined pattern are formed on the cylindrical surface of the printing cylinder 30. More precisely, the recessed portions in the predetermined pattern are three rectangles sequentially arranged in the rotation direction of the printing cylinder 30 as shown in Fig. 4.

The resin bath 34 for supplying a resin material 25 is disposed below the printing cylinder 30. The recessed portions formed in the cylindrical surface of the printing cylinder 30 are soaked in the resin material 25 stored in the resin bath 34. The resin material 25 is filled into the recessed portions of the printing cylinder 30 with the rotation of the printing cylinder 30.

The blanket 32 is composed, for example, of a shaft center formed of aluminium, and a peripheral portion formed of an elastic material. A silicon rubber, acrylonitrile-butadiene rubber or the like can be used to form the peripheral portion.

The blanket 32 rotates about the shaft center of the blanket 32 in an arrow β direction as shown in Fig. 3. specifically, synchronously with the rotation of the printing cylinder 30, the blanket 32 rotates in the reverse direction to the rotation direction of the printing cylinder 30. The elastic cylindrical surface of the blanket 32 comes into contact with the cylindrical surface of the printing cylinder 30. With this contact, the resin material 25 filled in the recessed portions of the printing cylinder 30 is applied in a predetermined pattern to the cylindrical surface of the blanket 32.

To be more precise, the resin material 25 is formed on the cylindrical surface of the blanket 32 in the predetermined pattern corresponding to the recessed portions of the printing cylinder 30.

Hereinbelow, descriptions will be provided for a process of transferring the resin material 25 formed in the predetermined pattern on the cylindrical surface of the blanket 32, to the light receiving surface of the solar cell substrate 10.

The solar cell substrates 10 are mounted on a movable belt. At this time, the moving direction of the solar cell substrates 10 is set to the first direction in which the thin wire electrodes 14 extend on the light receiving surface of the solar cell substrate 10.

Then, the blanket 32 is rotated in the first direction on the light receiving surface of the solar cell substrate 10. Specifically, the arrow β direction in which the blanket 32 rotates on the light receiving surface of the solar cell substrate 10 is set to agree with the first direction in which the thin wire electrodes 14 extend. Thereby, the resin material 25 formed in the predetermined pattern on the cylindrical surface of the blanket 32 is transferred to the light receiving surface of the solar cell substrate 10 sequentially in the first direction. The resin material 25 formed in the predetermined pattern is not applied to the bus bar electrodes 16.

Thereafter, the resin material 25 transferred to the light receiving surface of the solar cell substrate 10 is dried to form the surface protection layers 20. In this way, the solar cell 1 is fabricated.

### (Effects)

When a surface protection layer is formed in the printing method using a blanket, the surface protection layer is sometimes not formed around thin wire electrodes on a surface of a solar cell substrate. The present inventors found a knowledge that this problem is caused when the direction in which the thin wire electrodes extends on the surface of the solar cell substrate is different from the direction in which the blanket rotates.

To be more precise, when the blanket rotates in the second direction on the surface of the solar cell substrate, the blanket needs to run over the multiple thin wire electrodes one by one. In this case, since the peripheral portion of the blanket is elastic, the peripheral portion of the blanket is recessed inwardly every time the blanket runs over the thin wire electrode. Accordingly, a gap likely occurs between the blanket and a portion around the thin wire electrode on the surface of the solar cell substrate. As a result of the occurrence of such a gap, the surface protection layer is sometimes not formed around the thin wire electrode on the surface of the solar cell substrate.

According to the solar cell manufacturing method of this embodiment, in the process of transferring the resin material 25 applied to the blanket 32, to the light receiving surface of the solar cell substrate 10, the blanket 32 is rotated on the light receiving surface of the solar cell substrate 10 in the first direction in which the thin wire electrodes 14 each extend.

In this way, the blanket 32 rotates on the light receiving surface of the solar cell substrate 10 in the first direction, and thereby the blanket 32 does not need to run over the multiple thin wire electrodes 14 one by one. This prevents a gap from occurring between the blanket 32 and a portion around the thin wire electrode 14 on the light receiving surface of the solar cell substrate 10. Consequently, the surface protection layer 20 can be formed uniformly on the light receiving surface of the solar cell substrate 10.

Since the surface protection layer 20 can be formed uniformly as described above, the moisture resistance of the solar cell 1 is improved and accordingly the solar cell substrate 10 is prevented from being damaged.

Moreover, according to the solar cell manufacturing method of this embodiment, the resin material is transferred to the light receiving surface of the solar cell substrate 10 to be located away from connection areas to which wiring members are to be connected.

Thus, since the resin material is not transferred to the connection areas, the wiring member and the connection area can be electrically and mechanically coupled to each other to a sufficient extent.

### [Example 1]

Hereinafter, the solar cell module manufacturing method according to the present invention will be specifically described by taking one example. The present invention, however, is not limited to the example described below, and can be implemented, with modification as required, without departing from the spirit of the present invention.

### (Example)

A solar cell according to this example was fabricated as follows.

Firstly, a solar cell substrate was prepared. On a light receiving surface of the solar cell substrate, multiple thin wire electrodes were formed in a first direction and bus bar electrodes were formed in a second direction substantially perpendicular to the first direction.

Then, an acrylic resin was transferred to the light receiving surface of the solar cell substrate in the first direction by use of the offset printing method. Thus, the surface protection layer was formed on the light receiving surface of the solar cell substrate.

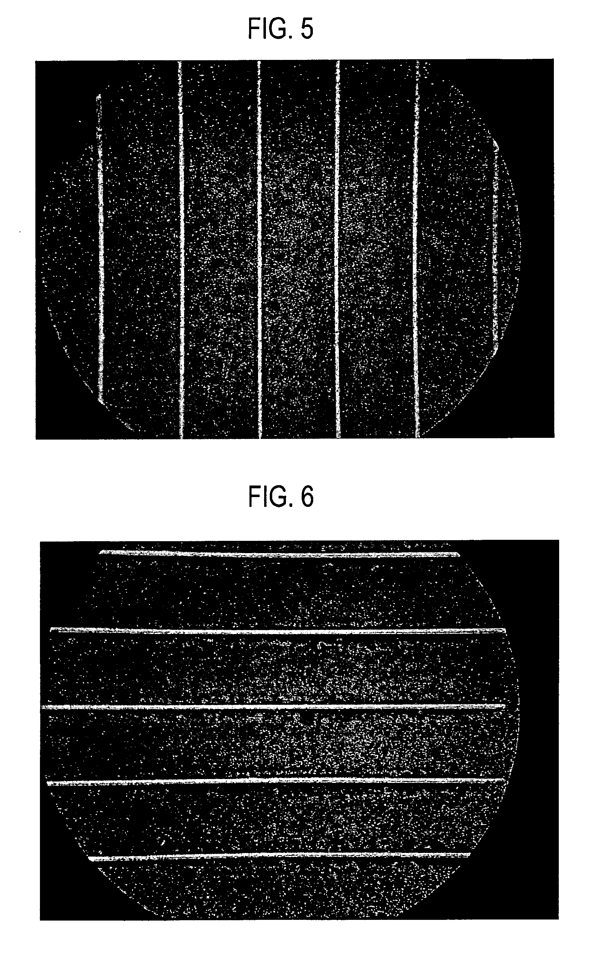

Fig. 5 is a magnified photograph of the light receiving surface of the solar cell in this example. As shown in Fig. 5, the acrylic resin was uniformly transferred without including any empty spots.

### (Comparative Example)

A solar cell in a comparative example was fabricated as follows.

The same solar cell substrate as that in the above example was prepared.

Then, an acrylic resin was transferred to the light receiving surface of the solar cell substrate in the second direction by use of the offset printing method.

Fig. 6 is a magnified photograph of the light receiving surface of the solar cell in the comparative example. As shown in Fig. 6, the acrylic resin was transferred unevenly with causing empty spots around the thin wire electrodes.

### (Moisture Resistance Test)

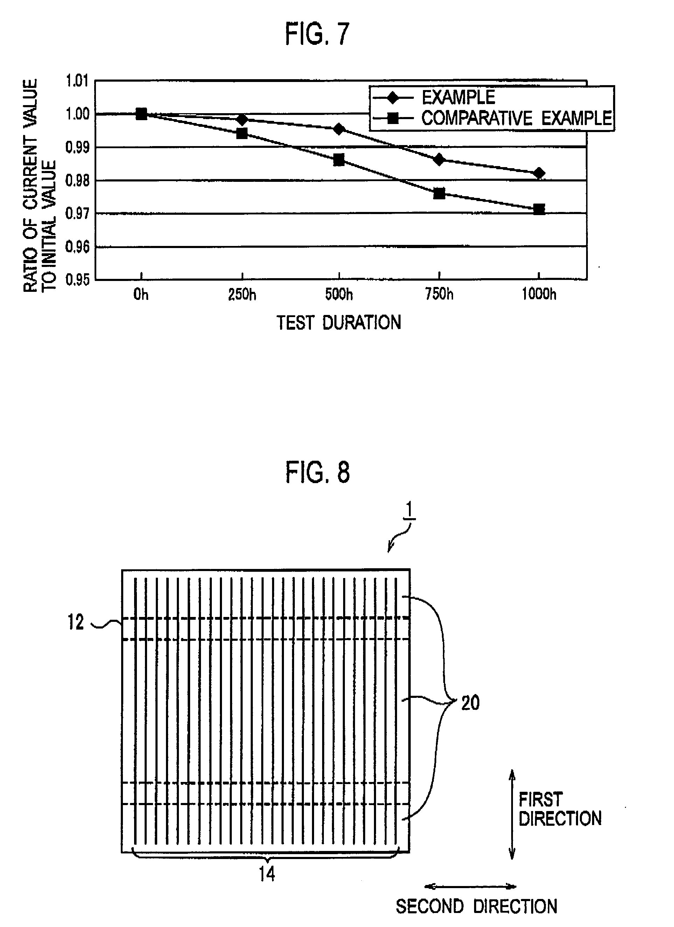

The solar cells of the above example and the comparative example were tested in terms of the moisture resistance. Fig. 7 is a diagram showing how the output values of the solar cells of the example and the comparative example changed over time when the solar cells were exposed to an environment at a temperature of 85 °C and at a humidity of 85% for 1000 hours. Incidentally, Fig. 7 shows the output values of the solar cells of the example and comparative example normalized with the initial output values before the moisture resistance test set at 1.00.

As shown in Fig. 7, the change in the output value of the example is smaller than that in the comparative example. This is because the acrylic resin was uniformly transferred to the light receiving surface without including any empty spots in the example, thereby increasing the moisture resistance of the solar cell while the acrylic resin is transferred unevenly in the comparative example, thereby decreasing the moisture resistance of the solar cell.

Thus, it was confirmed that the moisture resistance of the solar cell can be improved by setting the direction of forming the surface protection layer to agree with the extending direction of the thin wire electrodes.

### (Other Embodiments)

Although the present invention has been described based on the foregoing embodiment, it should not be understood that the description and drawings constituting part of this disclosure limit the present invention. Alternative embodiments, examples and application techniques should be obvious to those skilled in the art from this disclosure.

For instance, although it has been described that the solar cell substrate includes the bus bar electrodes in the foregoing embodiment, the solar cell substrate may not have any bus bar electrode but may have wiring members directly connected to the thin wire electrodes as shown in Fig. 8. Even in this case, a resin material as the surface protection layer is transferred to be located away from a connection area to which the wiring members are to be connected.

Moreover, although the foregoing embodiment has been described for the case where the surface protection layer is formed only on the light receiving surface of the solar cell substrate, the surface protection layers may be formed only on the back surface of the solar cell substrate. Instead, the surface protection layers may be formed on both the light receiving surface and the back surface of the solar cell substrate. Note that, when the surface protection layer is formed only on any one of the light receiving surface and the back surface of the solar cell substrate, it is preferable to form the surface protection layer on the side closer to an area in which a pn semiconductor junction is formed inside the solar cell substrate. This is because when the pn semiconductor junction is degraded due to the moisture permeating the solar cell, the output of the solar cell is more likely to decrease.

Additionally, although the method of forming the surface protection layer by use of the offset printing method has been described in the above embodiment, the surface protection layer may be formed by use of a roll coater method, for example. The present invention is able to produce its effect in the case of using any printing method with a blanket.

Further, although the above embodiment has been described for the case where the collecting electrodes (the thin wire electrodes and the bus bar electrodes) are formed in the comb-like shape on the back surface of the photoelectric conversion part, the collecting electrodes may be formed to cover over the entire back surface of the photoelectric conversion part. The present invention does not limit the shape of collecting electrodes formed on the back surface of the photoelectric conversion part.

Furthermore, although the foregoing embodiment has been described for the case where the thin wire electrode is formed in a line shape extending in the first direction on the light receiving surface of the photoelectric conversion part, the form of the thin wire electrode may be different from the line shape. Accordingly, even when the thin wire electrode is formed in a wave line shape extending in the first direction, the present invention is able to produce the effect.

As described above, the present invention obviously includes various embodiments not described herein. The technical scope of the present invention is only defined by the subject matters according to the scope of the claims appropriate based on the foregoing description.

## Claims

1. A method of manufacturing a solar cell including: a solar cell substrate having a photoelectric conversion part configured to generate photogenerated carriers by receiving light, and a plurality of thin wire electrodes configured to collect the photogenerated carriers from the photoelectric conversion part; and a surface protection layer formed on a main surface of the solar cell substrate, the method comprising:
a step A of forming the solar cell substrate by forming the plurality of thin wire electrodes each extending in a predetermined direction on a main surface of the photoelectric converter;
a step B of applying a resin material to a cylindrical surface of a cylindrical blanket; and
a step C of forming the surface protection layer by transferring the resin material to the main surface of the solar cell substrate, wherein
the step C comprises rotating the blanket on the main surface of the solar cell substrate in the predetermined direction.

2. The solar cell manufacturing method according to claim 1, wherein
the solar cell substrate further includes a bus bar electrode configured to collect the photogenerated carriers from the plurality of thin wire electrodes,
the step A comprises forming the bus bar electrode on the main surface of the photoelectric conversion part so that the bus bar electrode intersects the plurality of thin wire electrodes,
the step B comprises transferring the resin material so that the resin material is located away from the bus bar electrode.
